# EUROPÄISCHE PATENTSCHRIFT

(11) **EP 0 440 901 B1**
(45) Veröffentlichungstag und Bekanntmachung des Hinweises auf die Patenterteilung: **08.02.1995**
(21) Anmeldenummer: 90122686.0
(22) Anmeldetag: 27.11.1990
(51) Int. Cl.: H01J 37/26, H01J 37/05, G01R 31/302

(54) **Ionenstrahlgerät sowie Verfahren zur Durchführung von Potentialmessungen mittels eines Ionenstrahles**
Ion beam apparatus as well as a process to perform potential measurements by means of an ion beam
Appareil à faisceau d'ions et procédé pour effectuer des mesures de potentiel par un faisceau d'ions

(30) Priorität: 10.01.1990 DE 4000579
(43) Veröffentlichungstag der Anmeldung: 14.08.1991
(73) Patentinhaber: ICT Integrated Circuit Testing Gesellschaft für Halbleiterprüftechnik mbH, D-85551 Kirchheim (DE); ADVANTEST CORPORATION, Shinjuku-ku, Tokyo 163-08 (JP)
(72) Erfinder: Frosien, Jürgen, Dr.-Ing., W-8012 Riemerling (DE)
(74) Vertreter: Tetzner, Volkmar, Dr.-Ing. Dr. jur.

(56) Entgegenhaltungen:
- DE-A- 3 703 028
- ELECTRONICS LETTERS, Band 23, Nr. 11, 21. Mai 1987, Seiten 585-586, Stevenage, GB ; E.C.G. KIRK et al. : "Observation of voltage contrast in scanning ion microscopy of integrated circuits"
- PATENT ABSTRACTS OF JAPAN, Band 8, Nr. 39 (E-228)[1476], 21. Februar 1984 ; & JP-A-58 197 644

## Beschreibung

Die Erfindung betrifft ein Ionenstrahlgerät (gemäß dem Oberbegriff des Anspruches 1) sowie ein Verfahren zur Durchführung von Potentialmessungen an Strukturen in integrierten Schaltungen (gemäß dem Gattungsbegriff der Ansprüche 5 und 6).

Für die Fehleranalyse und Spannungsmessung in integrierten Schaltungen wird gegenwärtig die Elektronenstrahlmeßtechnik eingesetzt. Sie stößt jedoch bei modernen Schaltungen an gewisse Grenzen, die sich nur schwer überwinden lassen.

So liegen in modernen Schaltungen vielfach Mehrlagenverdrahtungen vor, so daß ein Teil der interessierenden Meßstellen für den Elektronenstrahl nicht zugänglich ist.

Schaltungen sind weiterhin mit einer isolierenden Passivierungsschicht bedeckt, die vor der Messung entfernt werden muß, da durch die Passivierungsschicht hindurch nur qualitative, nicht quantitative Messungen erfolgen können.

Aufgrund der erforderlichen niedrigen Elektronenenergie des abtastenden Elektronenstrahles wirken sich ferner elektrische und magnetische Felder, die durch die Probe erzeugt werden, störend aus. Diese Felder lenken den Primärelektronenstrahl ab, so daß es schwierig ist, ihn auf der zu untersuchenden Leiterbahn zu halten.

Zur Lösung der beiden erstgenannten Probleme sind Ionenstrahlgeräte bekannt, mit denen Löcher durch obere Metallebenen oder durch Passivierungsschichten geätzt werden, um die interessierende Meßstelle freizulegen. Ein Ionenstrahlgerät dieser Art ist beispielsweise in "Proceedings of the Intern. Reliability Physics Symposion, 1989, S. 43-52 beschrieben.

Für die eigentliche Potentialmessung ist jedoch nach dem Ätzvorgang ein gesonderter Elektronenstrahltester erforderlich. Es werden somit zwei separate Geräte benötigt, was nicht nur teuer, sondern auch sehr zeitaufwendig ist, da die interessierende Stelle jedesmal neu aufgesucht werden muß. Zudem ergibt sich die Schwierigkeit, daß die Probe erneut in das Ionenstrahlgerät gebracht werden muß, wenn eine neue, vorher nicht präparierte Meßstelle benötigt wird.

Für die Lösung des dritten eingangs genannten Problemes (Ablenkung des Elektronenstrahles durch Störeinflüsse) sind bisher aufwendige elektronische Kompensationsverfahren erforderlich.

Der Erfindung liegt daher die Aufgabe zugrunde, ein Ionenstrahlgerät gemäß dem Oberbegriff des Anspruches 1 dahin weiterzuentwickeln , daß hiermit nicht nur das Ätzen von Löchern, sondern auch die Durchführung von sehr genauen Potentialmessungen möglich ist. Weitere Aufgabe der Erfindung ist es, das mit einem derartigen Ionenstrahlgerät zur Anwendung kommende Verfahren zur Durchführung von Potentialmessungen dahin weiterzuentwikkeln, daß der während der Messung erfolgende Abtrag von Probenmaterial kompensiert wird.

Diese Aufgabe wird erfindungsgemäß durch die kennzeichnenden Merkmale der Ansprüche 1, 5 und 6 gelöst. Zweckmäßige Ausgestaltungen der Erfindung sind Gegenstand der Unteransprüche.

Es ist bekannt, daß beim Bohren von Löchern mittels eines Ionenstrahlgerätes der Ionenstrahl beim Auftreffen auf die Probe Sekundärelektronen auslöst. Dieser Effekt wurde bereits dazu ausgenutzt, mit einem Ionenstrahlgerät Potentialkontrastbilder einer Schaltung zu erzeugen ("Electronics Letters" 23, 1987, 11, S.585). Hierbei handelt es sich jedoch nicht um die Durchführung quantitativer Potentialmessungen.

Bei den der Erfindung zugrundeliegenden eingehenden Versuchen wurde zunächst erprobt, zwischen der Objektivlinse eines Ionenstrahlgerätes und der Probe ein Sekundärelektronenspektrometer anzuordnen, d.h. eine Extraktionselektrode, eine Filterelektrode und einen Sekundärelektronendetektor mit Szintillator (wobei die genannten Elemente über einen äußeren Regelkreis miteinander verbunden sind).

Bei diesen Versuchen stellte sich jedoch heraus, daß sich bei einer derartigen Anordnung ein zu großer Arbeitsabstand zwischen der Objektivlinse und der Probe ergibt, was die Linsenfehler der Objektivlinse (insbesondere den axialen Farbfehler und den Öffnungsfehler) erhöht und dadurch die Ortsauflösung des Gerätes verringert.

Eine einwandfreie Lösung der oben genannten Aufgabe läßt sich dagegen erfindungsgemäß durch die Kombination folgender Merkmale erzielen:
- In das Ionenstrahlgerät ist ein Sekundärelektronenspektrometer integriert, das eine Extraktionselektrode, eine Filterelektrode, einen Szintillator sowie einen den Szintillator mit der Filterelektrode verbindenden Regelkreis enthält;
- der Szintillator wird hierbei durch die mittlere Elektrode der Objektivlinse gebildet.

Wird auf diese Weise das Sekundärelektronenspektrometer in die Objektivlinse integriert, so wird damit das Ionenstrahlgerät zu einem Ionenstrahltester erweitert, mit dem alle bekannten Techniken der Elektronenstrahlmeßtechnik, insbesondere die quantitative Spannungsmessung, durchgeführt werden können. Von besonderem Vorteil ist hierbei - im Unterschied zu der vorstehend genannten, noch nicht zufriedenstellenden Version - , daß durch die Integration des Sekundärelektronenspektrometers in die Objektivlinse der Arbeitsabstand zwischen Objektivlinse und Probe minimal gehalten werden kann, wodurch die Linsenfehler der Objektivlinse reduziert werden und die Ortsauflösung des Gerätes erhöht wird.

Bei der erfindungsgemäßen Ausführung ist die Extraktionselektrode des Sekundärelektronenspektrometers dicht oberhalb der Probe angebracht. In einem geringen Abstand (von wenigen mm) folgt die Filterelektrode des Spektrometers. Der Szintillator des Sekundärelektronendetektors ist direkt in die mittlere Elektrode der Objektivlinse integriert. Dies ist möglich, da sich die mittlere Elektrode der Objektivlinse auf hohem positiven Potential befindet und daher alle Sekundärelektronen, die die Filterelektrode passieren, dort landen.

Das vom Szintillator erzeugte Licht wird direkt über Lichtleiter oder über ein optisches System einem Multiplier zugeführt, der das Lichtsignal in ein elektrisches Signal umwandelt, das dann in bekannter Weise weiterverarbeitet wird.

Der wesentliche Vorteil des erfindungsgemäßen Ionenstrahlmeßgerätes besteht darin, daß mit demselben Gerät, mit dem Löcher in der Metallisierung oder Passivierung einer Schaltung erzeugt werden, zugleich auch die elektrische Potentialmessung erfolgen kann. Bohrungen müssen daher nur an den wirklich benötigten Stellen durchgeführt werden, was einen erheblichen Zeitvorteil mit sich bringt.

Da ein einfallender Ionenstrahl mehr Sekundärelektronen auslöst als ein Elektronenstrahl, ergibt sich - verglichen mit einem Elektronenstrahltester - ein größeres auswertbares Signal, was die Meßgenauigkeit und/oder die Meßgeschwindigtkeit erhöht.

Mit einem Ionenstrahl kann ferner bei höheren Primärenergien als mit einem Elektronenstrahl gearbeitet werden. Ein 30 keV Ionenstrahl besitzt die gleiche Eindringtiefe wie ein niederenergetischer Elektronenstrahl im 1 keV Bereich. Dementsprechend kann auch ein hochenergetischer Ionenstrahl für eine schädigungsfreie Messung innerhalb der Schaltung benutzt werden. Der hochenergetische Primärstrahl hat aber den Vorteil, daß elektrische und magnetische Störfelder in Probennähe, die zum Teil von der Probe selbst erzeugt werden, nicht mehr stören. Dies ermöglicht ein genaues und stabiles Aufsetzen der Ionensonde auf die Probe.

Die zumindest teilweise Integration des Sekundärelektronenspektrometers in die Objektivlinse ermöglicht einen kurzen Arbeitsabstand und eine hohe Ortsauflösung und damit eine Messung auch auf feinsten Strukturen.

Die Erfindung läßt sich natürlich auch auf Systeme mit Immersionslinsen übertragen. Bei diesen Geräten ist die Ionenenergie im oberen Teil der Säule hoch. Die Ionen werden erst in der Objektivlinse auf die gewünschte End-Energie abgebremst. Dies hat den Vorteil, daß die Fehlerkoeffizienten der Objektivlinse weiter verbessert werden können, da Gegenfeldanordnungen generell die besseren optischen Eigenschaften besitzen.

Eine gewisses Problem stellt bei dem erfindungsgemäßen Ionenstrahlgerät der Umstand dar, daß durch den Ionenstrahl während der Messung von der Probe Material abgetragen wird. Rechnungen zeigen jedoch, daß eine Potentialmessung so schnell erfolgen kann, daß dieser Abtrag in den meisten Fällen vernachlässigbar und daher nicht störend ist.

Sollten in Ausnahmefällen die Strukturen, auf denen gemessen wird, so fein oder so dünn sein, daß der Abtrag negative Auswirkungen haben kann, so können erfindungsgemäß folgende Kompensationsmaßnahmen ergriffen werden:
- Der Ionenstrahl wird während der Messung in der Richtung gerastert, in der die Struktur ausgedehnt ist.
- Während der Messung wird ein leitendes Material (z.B. ein Metall) abgeschieden, das den Abtrag ausgleicht. Verfahren zur ionenstrahlinduzierten Abscheidung sind aus der Literatur bekannt.

Die beiden vorstehend genannten Kompensationsmaßnahmen können selbstverständlich auch kombiniert zur Anwendung kommen.

Ein Ausführungsbeispiel der Erfindung ist in der Zeichnung veranschaulicht. Es zeigen
- Fig.1: eine Schemadarstellung eines Ionenstrahlgerätes mit integriertem Sekundärelektronenspektrometer,
- Fig.2: eine Variante zu Fig. 1.

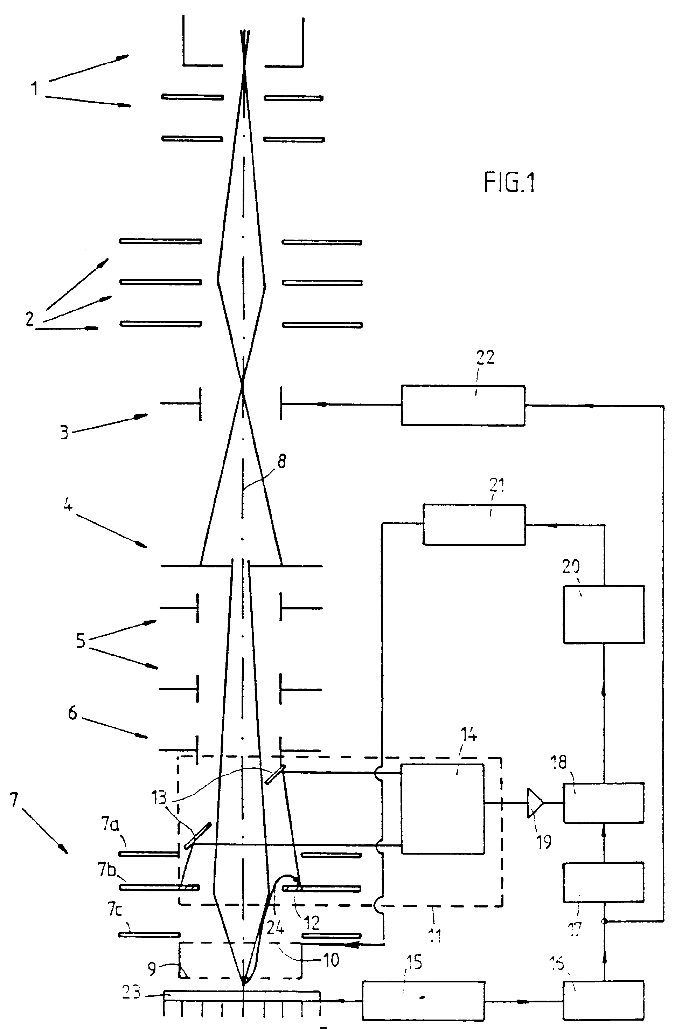

Das in Fig.1 dargestellte Ionenstrahlmeßgerät enthält eine Ionenquelle 1, eine Kondensorlinse 2, ein Austastsystem 3, eine Aperturblende 4, eine Ablenkeinrichtung 5, einen Stigmator 6 sowie eine Objektivlinse 7, die drei in Strahlrichtung hintereinander angeordnete, rotationssymmetrische Elektroden 7a, 7b, 7c enthält, wobei die Achse 8 des Ionenstrahles mit der Achse der Objektivlinse 7 zusammenfällt.

In das Ionenstrahlgerät ist ein Sekundärelektronenspektrometer integriert, das im wesentlichen eine Extraktionselektrode 9, eine Filterelektrode 10, einen Sekundärelektronendetektor 11 und einen noch näher zu erläuternden Regelkreis enthält.

Der Sekundärelektronendetektor 11 besteht im wesentlichen aus einem Szintillator 12, der durch den inneren Bereich der mittleren Elektrode 7b der Objektivlinse 7 gebildet wird, ferner aus einem Spiegel 13 (oder einer sonstiger Optik) sowie einem Multiplier 14. Stattdessen kann der Szintillator 12 auch über einen Lichtleiter mit dem Multiplier 14 verbunden sein.

Der äußere Regelkreis enthält einen Taktgeber 15, eine Phasensteuerung 16, eine Verzögerungseinrichtung 17, eine Torsteuerung 18, einen Vorverstärker 19, eine signalverarbeitende Schaltung 20 sowie einen Verstärker 21, dessen Ausgang an die Filterelektrode 10 angeschlossen ist.

Der mit der Verzögerungseinrichtung 17 verbundene Ausgang der Phasensteuerung 16 ist weiterhin über einen Pulsgenerator 22 an das Austastsystem 3 angeschlossen.

Die Funktion des Ionenstrahlmeßgerätes bei der Potentialmessung (d.h. nach dem Bohren eines Loches) ist wie folgt:

Das allgemeine Prinzip des Regelkreises besteht darin, das Sekundärelektronensignal auf konstanten Strom zu regeln und gleichzeitig die Phasensteuerung für das Ionenstrahl-Austastsystem 3 zu erzeugen.

Die vom Ionenstrahl beim Auftreffen auf die Probe 23 ausgelösten Sekundärelektronen (Pfeil 24) müssen nach Passieren der Extraktionselektrode 9 zunächst die Filterelektrode 10 passieren. Da die Filterelektrode auf einem bestimmten negativen Potential liegt (das - wie noch erläutert wird - vom Regelkreis gesteuert wird), werden nur die wenigen Sekundärelektronen durch die Filterelektrode 10 durchgelassen, die eine genügend hohe Energie besitzen.

Wenn sich das Potential an der untersuchten Stelle der Probe 23 ändert, verschiebt sich die Energieverteilung der Sekundärelektronen und es kommen entsprechend mehr oder weniger Elektronen zum Szintillator 12 des Sekundärelektronendetektors 11. Nunmehr wird das Potential der Filterelektrode 10 so nachgeregelt, daß der Sekundärelektronenstrom konstant bleibt. Das Potential der Filterelektrode 10 wird somit in Abhängigkeit von dem zu messenden Potential auf der Probe 23 geändert. Damit stellt das sich ändernde Potential der Filterelektrode 10 ein Maß für das zu messende Potential der Probe 23 dar.

Im einzelnen arbeitet der äußere Regelkreis wie folgt:

Der Sekundärelektronendetektor 11 wandelt das Sekundärelekronensignal in ein elektrisches Signal um, das nach Verstärkung im Vorverstärker 19 durch die Torsteuerung 18 abgetastet wird. Diese Abtastung wird durch den Taktgeber 15 gesteuert, der zugleich auch die zu untersuchende Probe 23 treibt. Die Phasensteuerung 16 ermöglicht hierbei die Einstellung des Abtastzeitpunktes.

Vom Ausgang der Phasensteuerung 16 wird über den Pulsgenerator 22 das Austastsystem 3 des Ionenstrahles gesteuert. Um die Laufzeit des Ionenstrahles vom Austastsystem 3 bis zur Probe 23 zu berücksichtigen, ist die Verzögerungseinrichtung 17 vorgesehen.

In der signalverarbeitenden Schaltung 20 wird das über die Torsteuerung 18 abgetastete Ausgangssignal des Vorverstärkers 19 gemittelt, um das Signal-Rausch-Verhältnis zu verbessern. Mittels eines Komparators wird ein Vergleich mit einem Referenzwert durchgeführt, der dem gewünschten konstanten Sekundärelektronenstrom entspricht. Das Ausgangssignal gelangt über den Verstärker 21 zur Filterelektrode 10 und hält in der bereits erläuterten Weise durch Änderung des negativen Potentiales der Filterelektrode 10 den Sekundärelektronenstrom konstant, auch wenn sich das zu messende Potential auf der untersuchten Stelle der Probe 23 ändert.

Statt eines Austastsystems 3 zum Austasten (Blanken) des Ionenstrahles kann im Rahmen der Erfindung selbstverständlich auch eine gepulste Ionenquelle Verwendung finden.

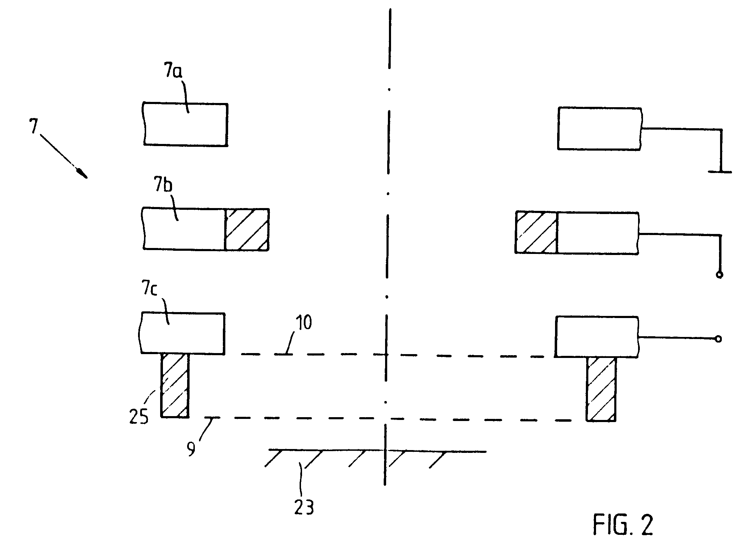

Während bei dem Ausführungsbeispiel gemäß Fig.1 die Extraktionselektrode 9 und die Filterelektrode 10 zwischen der Probe 23 und der der Probe 23 benachbarten Elektrode 7c der Objektivlinse 7 angeordnet sind, zeigt Fig.2 ein Ausführungsbeispiel, bei dem die Filterelektrode 10 auf Höhe der der Probe 23 benachbarten Elektrode 7c der Objektivlinse 7 angeordnet und auf gleichem Potential wie diese Elektrode gehalten ist, während die Extraktionselektrode 9 zwischen dieser Elektrode 7c und der Probe 23 angeordnet ist (die Extraktionselektrode 9 ist hierbei mittels eines isolierenden Elementes 25 an der Elektrode 7c gehaltert).

Während sich bei dem Ausführungsbeispiel gemäß Fig.1 die Elektroden 7a und 7c auf erdnahem Potential befinden und die mittlere Elektrode 7b stark positiv geladen ist, entfällt beim Ausführungsbeispiel gemäß Fig.2 die Erdverbindung der Elektrode 7c, da diese Elektrode 7c elektrisch mit der vom Regelkreis gesteuerten Filterelektrode 7c verbunden ist.

Bei dem erfindungsgemäßen Ionenstrahlgerät kann die Objektivlinse 7 auch durch eine elektrostatische Bremslinse gebildet werden. Eine Bremslinse zeichnet sich dadurch aus, daß die Ionenenergie vor der Linse (d. h. quellenseitig) höher ist als die Ionenenergie nach der Linse (d. h. probenseitig). Dies wird durch eine entsprechende Wahl der Spannungen an der ersten und dritten Elektrode (7a bzw. 7c) erreicht. Bei einer Bremslinse ist das Spannungspotential der Elektrode 7c positiver als das der Elektrode 7a.

## Patentansprüche

1. Ionenstrahlgerät, enthaltend
a) eine Einrichtung (1, 3) zur Erzeugung eines gepulsten Ionenstrahles,
b) eine Ablenkeinrichtung (5) zur Ablenkung des Ionenstrahles,
c) eine den Ionenstrahl auf eine Probe (23) fokussierende elektrostatische Objektivlinse (7), die drei in Strahlrichtung hintereinander angeordnete, rotationssymmetrische Elektroden (7a, 7b, 7c) enthält, wobei die Achse (8) des Ionenstrahls mit der Achse der Objektivlinse zusammenfällt,
gekennzeichnet durch folgende Merkmale:
d) in das Ionenstrahlgerät ist ein Sekundärelektronenspektrometer integriert, das eine Extraktionselektrode (9), eine Filterelektrode (10), einen Szintillator (12) sowie einen den Szintillator mit der Filterelektrode verbindenden Regelgkreis enthält;
e) der Szintillator (12) wird durch die mittlere Elektrode (7b) der Objektivlinse (7) gebildet.

2. Ionenstrahl nach Anspruch 1, dadurch gekennzeichnet, daß die Extraktionselektrode (9) und die Filterelektrode (10) zwischen der Probe (23) und der der Probe benachbarten Elektrode (7c) der Objektivlinse (7) angeordnet sind.

3. Ionenstrahlgerät nach Anspruch 1, dadurch gekennzeichnet, daß die Filterelektrode (10) auf Höhe der der Probe (23) benachbarten Elektrode (7c) der Objektivlinse (7) angeordnet und auf gleichem Potential wie diese Elektrode gehalten ist, während die Extraktionselektrode (9) zwischen dieser Elektrode (7c) und der Probe (23) vorgesehen ist.

4. Ionenstrahlyerät nach Anspruch 1, dadurch gekennzeichnet, daß die Objektivlinse durch eine elektrostatische Bremslinse gebildet wird.

5. Verfahren zur Durchführung von Potentialmessungen an Strukturen in integrierten Schaltungen, gekennzeichnet durch die Verwendung eines Ionenstrahlgerätes gemäß einem der Ansprüche 1 bis 4, wobei der Ionenstrahl während der Messung in der Richtung gerastert wird, in der die Struktur ausgedehnt ist.

6. Verfahren zur Durchführung von Potentialmessungen an Strukturen in integrierten Schaltungen, gekennzeichnet durch die Verwendung eines Ionenstrahlgerätes gemäß einem der Ansprüche 1 bis 4, wobei zum Ausgleich des durch den Ionenstrahl bei der Messung abgetragenen Materiales ein diesen Abtrag ausgleichendes leitendes Material abgeschieden wird.

## Claims

1. Ion beam device, comprising
a) an arrangement (1, 3) for producing a pulsed ion beam,
b) a deflection arrangement (5) for deflecting the ion beam,
c) an electrostatic objective lens (7) which focusses the ion beam onto a testpiece (23) and contains three rotationally symmetrical electrodes (7a, 7b, 7c) which are arranged one behind the other in the beam direction, the axis (8) of the ion beam coinciding with the axis of the objective lens,
characterised by the following features:
d) a secondary electron spectrometer which contains an extraction electrode (9), a filter electrode (10), a scintillator (12) and a control circuit connecting the scintillator to the filter electrode is integrated into the ion beam device;
e) the scintillator (12) is formed by the central electrode (7b) of the objective lens (7).

2. Ion beam device as claimed in claim 1, characterised in that the extraction electrode (9) and the filter electrode (10) are arranged between the testpiece (23) and the electrode (7c) of the objective lens (7) adjacent to the testpiece.

3. Ion beam device as claimed in claim 1, characterised in that the filter electrode (10) is arranged at the height of the electrode (7c) of the objective lens (7) adjacent to the testpiece (23) and is kept at the same potential as this electrode, whilst the extraction electrode (9) is arranged between this electrode (7c) and the testpiece (23).

4. Ion beam device as claimed in claim 1, characterised in that the objective lens is formed by an electrostatic retarding lens.

5. Method of carrying out potential measurements on structures in integrated circuits, characterised by the use of an ion beam device as claimed in one of Claims 1 to 4, in which during the measurement the ion beam is scanned in the direction in which the structure is expanded.

6. Method of carrying out potential measurements on structures in integrated circuits, characterised by the use of an ion beam device as claimed in one of Claims 1 to 4, in which in order to compensate for the material removed by the ion beam during the measurement a conductive material is deposited which equalises this removal.

## Revendications

1. Canon ionique, comprenant :
a) un dispositif (1, 3) de production d'un faisceau ionique pulsé,
b) un dispositif (5) de déviation du faisceau ionique,
c) une lentille électrostatique d'objectif (7) focalisant le faisceau ionique sur un échantillon (23) et comprenant trois électrodes (7a, 7b, 7c) symétriques de révolution et se succédant dans la direction du faisceau, l'axe du faisceau ionique coïncidant avec l'axe de la lentille de l'objectif,
caractérisé par les particularités suivantes :
d) un spectromètre des électrons secondaires qui est intégré dans le canon ionique comprend une électrode d'extraction (9), une électrode filtrante (10), un scintillateur (12) ainsi qu'un circuit de réglage reliant le scintillateur à l'électrode filtrante ;
e) le scintillateur (12) est formé par l'électrode centrale (7b) de la lentille (7) de l'objectif.

2. Canon ionique selon la revendication 1, caractérisé en ce que l'électrode d'extraction (9) et l'électrode filtrante (10) sont disposées entre l'échantillon (23) et l'électrode (7c) de la lentille (7) de l'objectif qui est voisine de l'échantillon.

3. Canon ionique selon la revendication 1, caractérisé en ce que l'électrode filtrante (10) est disposée au niveau de l'électrode (7c) de la lentille (7) de l'objectif qui est voisine de l'échantillon (23) et elle est maintenue au même potentiel que cette électrode, tandis que l'électrode d'extraction (9) est prévue entre cette électrode (7c) et l'échantillon (23).

4. Canon ionique selon la revendication 1, caractérisé en ce que la lentille de l'objectif est formée d'une lentille électrostatique de freinage.

5. Procédé pour effectuer des mesures de potentiel sur des structures de circuits intégrés, caractérisé par l'utilisation d'un canon ionique selon l'une des revendications 1 à 4, le faisceau ionique subissant pendant la mesure un balayage dans la direction dans laquelle la structure est étendue.

6. Procédé pour effectuer des mesures de potentiel sur des structures de circuits intégrés, caractérisé par l'utilisation d'un canon ionique selon l'une des revendications 1 à 4, une matière conductrice étant déposée pour compenser la matière enlevée par le faisceau ionique pendant la mesure.
